# DEMANDE DE BREVET EUROPEEN

(11) **EP 3 905 325 A1**
(43) Date de publication de la demande: **03.11.2021**
(21) Numéro de dépôt: 21170597.5
(22) Date de dépôt: 27.04.2021
(51) Int. Cl.: H01L 23/498

(54) **PROCEDE DE FABRICATION D'UN MODULE ELECTRONIQUE COMPATIBLE HAUTES FREQUENCES**

(30) Priorité: 27.04.2020 FR 2004163
(71) Demandeur: 3D Plus, 78530 Buc Cedex (FR)
(72) Inventeur: VAL, Christian, 78470 ST REMY LES CHEVREUSE (FR)
(74) Mandataire: Marks & Clerk France

(57) **Abrégé**

L'invention se situe dans le domaine de la fabrication de modules électroniques 3D, compatible des composants fonctionnant au-delà de 1 GHz. L'invention concerne un module électronique 3D présentant une interconnexion entre un conducteur horizontal (31, 32 ; 33, 34) et un conducteur vertical (30) auquel il est relié présente dans un plan vertical une courbure non nulle. Elle concerne aussi le procédé de fabrication associé.

## Description

La présente invention se situe dans le domaine de la fabrication de modules électroniques 3D, compatible des composants fonctionnant au-delà de 1 GHz. L'invention concerne un module électronique 3D. Elle concerne aussi son procédé de fabrication.

Dans un module électronique 3D, il y a plusieurs niveaux de composants empilés. Un circuit imprimé (Printed Circuit Board ou PCB) ou un module 3D comporte plusieurs niveaux horizontaux comportant des composants et des conducteurs électriques.

Les interconnexions en 3D peuvent être classées en trois groupes :
a. L'empilage de puces nues ou de boîtiers avec une interconnexion au moyen d'un bus métal ;
b. L'empilage de puces nues interconnectées par des trous traversant le silicium, encore nommé TSV pour l'abréviation de Thru Silicon Via ;
c. L'empilage de puces nues interconnectées par des fils de câblage, niveau après niveau.

Pour le premier groupe, afin d'interconnecter des puces empilées les unes sur les autres, les faces verticales de l'empilement qui sont métallisées sont utilisées pour réaliser les connexions électriques entre puces. Il en résulte que la technologie actuelle est basée sur une interconnexion dite en « T ». Chaque niveau empilé contient des conducteurs gravés dans un PCB qui sont reliés verticalement par un bus métal. Autrement dit, les interconnexions entre les niveaux 2D (plan d'un niveau) et 3D (empilement des différents niveaux) se font perpendiculairement, c'est-à-dire à 90°.

Pour le deuxième groupe, généralement, ces modules électroniques sont munis de trous percés verticalement, c'est-à-dire selon l'épaisseur du module. Les trous métallisés, souvent désignés vias, traversent ces niveaux et permettent ainsi de connecter verticalement ces conducteurs entre eux par contact entre les trous métallisés et les sections de ces conducteurs affleurant au niveau des trous. Dans la suite on désigne par trou un trou borgne (non traversant ou « blind hole » en anglais) ou un trou traversant. Bien sûr un module électronique peut comporter des trous borgnes et des trous traversants. Là encore, les conducteurs situés sur les différents plans empilés interceptent orthogonalement les trous.

Pour le troisième groupe, les nappes de fils de câblage superposées conduisent à des variations d'impédance importante et à des parasites selfiques. Elles ne peuvent être utilisées au-delà de 1 GHz.

Pour le premier et le deuxième groupes, on retient donc que l'interconnexion 3D est orthogonale, bien que les TSV soient de beaucoup plus petites dimensions que l'interconnexion avec bus métal.

Pour des composants fonctionnant au-delà de 1 GHz, l'interconnexion orthogonale, ou interconnexion en « T », conduit à des réflexions nuisibles à l'intégrité du signal. Dans le domaine des hyperfréquences d'un module électronique 3D, les connexions étant verticales sur les faces de l'empilement, les connexions en « T » entre conducteurs électriques (par exemple conducteurs issus des puces et conducteurs verticaux) sont disposées à angles droits. Une réflexion d'électrons se produit au niveau de la connexion, qui perturbe la connexion électrique et l'affaiblit.

En conséquence, il demeure à ce jour un besoin pour un procédé d'interconnexion de puces empilées permettant d'assurer l'intégrité des signaux aux hyperfréquences.

L'invention vise à pallier tout ou partie des problèmes cités plus haut en proposant une interconnexion grâce à laquelle le signal arrivant par un conducteur du PCB, d'une couche déposée de redistribution dite RDL ou un via suit une trajectoire courbe pour atteindre le bus métal.

A cet effet, l'invention a pour objet un module électronique 3D comprenant selon une direction dite verticale un empilement d'au moins deux boîtiers électroniques, le module étant apte à être assemblé à un circuit d'interconnexion, chacun des au moins deux boîtiers électroniques comprenant :
a. des composants munis de plots d'interconnexion orientés vers une surface supérieure des composants, lesdits composants étant au moins partiellement entourés de résine époxy, les plots d'interconnexion de chaque composant étant reliés par des couches de redistribution à des conducteurs verticaux eux-mêmes destinés à être électriquement reliés au circuit d'interconnexion du module, et
b. des conducteurs horizontaux, un conducteur horizontal et le conducteur vertical auquel il est relié formant un conducteur électrique entre un plot d'interconnexion d'un composant et le circuit d'interconnexion,
le module électronique 3D étant caractérisé en ce que l'interconnexion entre un conducteur horizontal et le conducteur vertical auquel il est relié présente dans un plan vertical une courbure non nulle.

Dans un mode de réalisation du module électronique 3D selon l'invention, les conducteurs verticaux sont des bus.

Dans un autre mode de réalisation du module électronique 3D selon l'invention, les conducteurs verticaux sont des vias.

Avantageusement, la courbure de l'interconnexion entre le conducteur horizontal et le conducteur vertical auquel il est relié forme une tangente avec le conducteur vertical.

L'invention concerne aussi un procédé de fabrication d'un module électronique 3D apte à être assemblé à un circuit d'interconnexion, caractérisé en ce qu'il comprend les étapes suivantes :
a. Report de composants munis de plots d'interconnexion sur une première surface d'une peau collante, une surface inférieure des composants étant en contact avec la peau collante et les plots d'interconnexion étant orientés vers une surface supérieure des composants ;
b. Dépôt d'une première résine époxy dans l'espace entre les composants et polymérisation de la résine pour obtenir un panneau;
c. Réalisation d'une rainure d'une première profondeur dans l'espace rempli de la première résine époxy, ladite rainure étant de forme évasée vers la surface supérieure du panneau et présentant latéralement une courbure ;
d. Métallisation du panneau rainuré;
e. Gravure par laser du panneau rainuré métallisé de sorte à isoler des conducteurs horizontaux ;
f. Dépôt d'une deuxième résine époxy dans l'espace formé par la rainure ;
g. Réalisation d'une ou plusieurs couches photogravées de redistribution sur la surface supérieure du panneau ;
h. Retrait de la peau collante pour obtenir une plaque ;
i. Dépôt d'une troisième résine époxy sur la surface supérieure de la plaque;
j. Empilement d'une deuxième plaque sur la plaque recouverte de la troisième résine époxy ;
k. Réalisation d'une rainure traversante dans l'espace rempli de la deuxième résine époxy;
l. Métallisation de la rainure traversante pour obtenir un conducteur vertical.

Selon un mode de réalisation du procédé selon l'invention, la première profondeur est inférieure à l'épaisseur de l'espace rempli de la première résine époxy.

Selon un autre mode de réalisation du procédé selon l'invention, la première profondeur est égale à l'épaisseur de l'espace rempli de la première résine époxy.

L'invention sera mieux comprise et d'autres avantages apparaîtront à la lecture de la description détaillée d'un mode de réalisation donné à titre d'exemple, description illustrée par le dessin joint dans lequel :

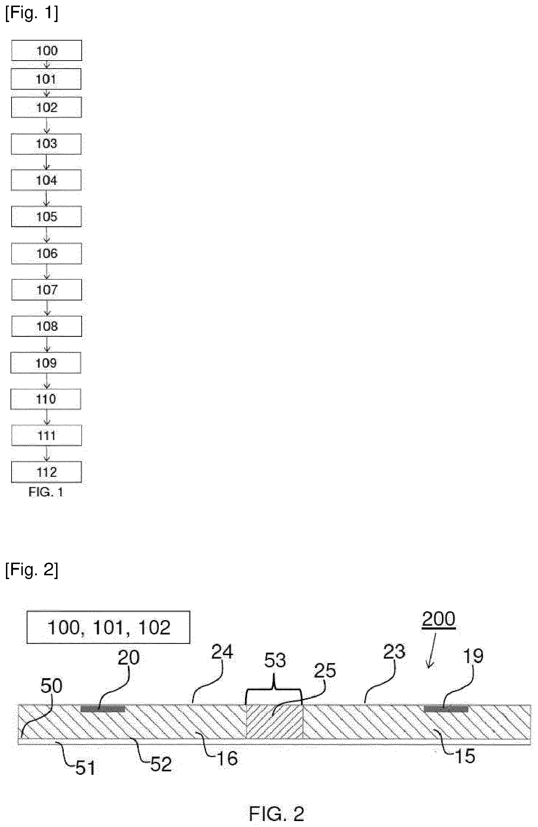

[Fig.1] la figure 1 illustre schématiquement les étapes du procédé de fabrication du module électronique 3D selon l'invention ;
[Fig.2]
[Fig.3]
[Fig.4]
[Fig.5]
[Fig.6]
[Fig.7] les figures 2 à 7 représentent schématiquement la succession des étapes du procédé de fabrication du module électronique 3D selon l'invention ;
[Fig.7] la figure 7 représente schématiquement une vue en coupe d'un module électronique 3D selon l'invention ;
[Fig.8] la figure 8 représente un mode de réalisation dans lequel le principe de l'invention est appliqué à un via ;
[Fig.9] la figure 9 représente schématiquement une variante du procédé de fabrication du module électronique 3D selon l'invention.

D'une figure à l'autre, les mêmes éléments sont repérés par les mêmes références.

Dans la suite de la description, les expressions « haut », « bas », sont utilisées en référence à l'orientation des figures décrites. Dans la mesure où le module électronique 3D peut être positionné selon d'autres orientations, la terminologie directionnelle est indiquée à titre d'illustration et n'est pas limitative.

La figure 1 illustre schématiquement les étapes du procédé de fabrication du module électronique 3D selon l'invention. Le procédé de fabrication d'un module électronique 3D selon l'invention comprend les étapes 100 à 112 réalisées successivement comme expliqué en details ci-dessous.

Les figures 2 à 7 représentent schématiquement la succession des étapes du procédé de fabrication du module électronique 3D selon l'invention.

Comme représenté sur la figure 2, le procédé de fabrication d'un module électronique 3D comprend une étape 100 de report de composants 15, 16 munis de plots d'interconnexion 19, 20 sur une première surface 50 d'une peau collante 51. Lors de ce report, une surface inférieure 52 des composants 15, 16 est en contact avec la peau collante 51 et les plots d'interconnexion 19, 20 sont orientés vers une surface supérieure 23, 24 des composants 15, 16.

Le procédé de fabrication selon l'invention comprend ensuite une étape 101 de dépôt d'une première résine époxy 25 dans l'espace 53 entre les composants 15, 16 et une étape 102 de polymérisation de la résine 25 pour obtenir un panneau 200.

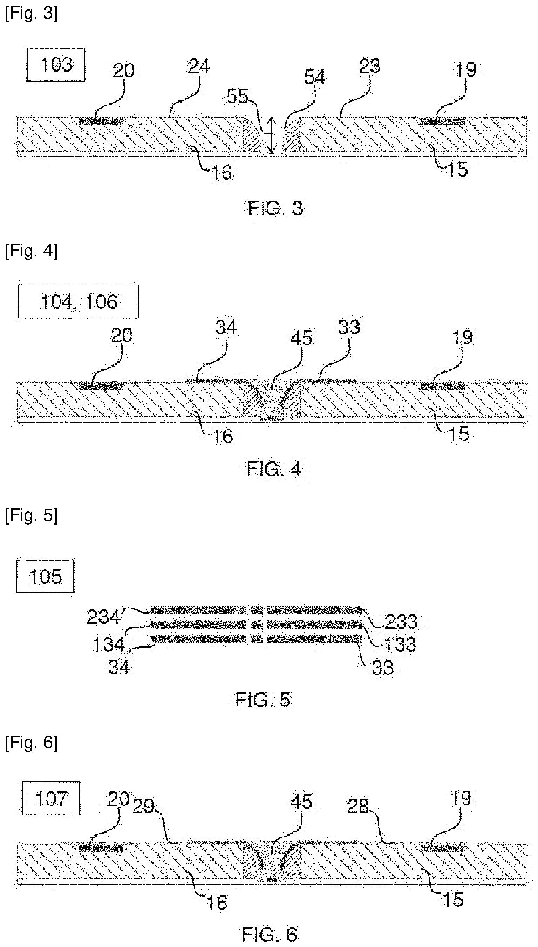

Le procédé de fabrication selon l'invention comprend une étape 103 de réalisation d'une rainure 54 d'une première profondeur 55 dans l'espace 53 rempli de la première résine époxy 25. Plus particulièrement, la rainure 54 est de forme évasée vers la surface supérieure du panneau 200 et présente latéralement une courbure. Cette rainure 54 peut être réalisée au moyen d'une scie de forme ayant une forme complémentaire de la rainure 54 représentée sur la figure 3. La rainure 54 peut également être réalisée au moyen de tout autre outil permettant d'enlever une partie de la résine 25 de sorte que la rainure résultante ait des parois latérales présentant une courbure. Avantageusement, la courbure est située dans la zone à proximité des surfaces supérieures 23, 24. Cette zone sera, une fois le procédé de fabrication réalisé, la zone d'interconnexion entre un conducteur horizontal et son conducteur vertical auquel le conducteur horizontal est relié. Il en résulte que l'interconnexion entre le conducteur horizontal et son conducteur vertical présente dans un plan vertical une courbure non nulle. L'avantage de cette interconnexion non orthogonale dans le domaine des hyperfréquences d'un module électronique 3D à connexions verticales sur les faces de l'empilement est d'éviter ainsi une réflexion d'électrons qui se produirait au niveau de la connexion, et qui perturberait la connexion électrique et l'affaiblit. Grâce à l'invention, le signal arrivant par le conducteur horizontal suivra une trajectoire courbe pour atteindre le conducteur vertical, comme expliqué ci-dessous. La courbure non nulle selon l'invention est une portion d'arc de cercle présentant une courbure régulière et ne résultant pas d'un recouvrement de surface.

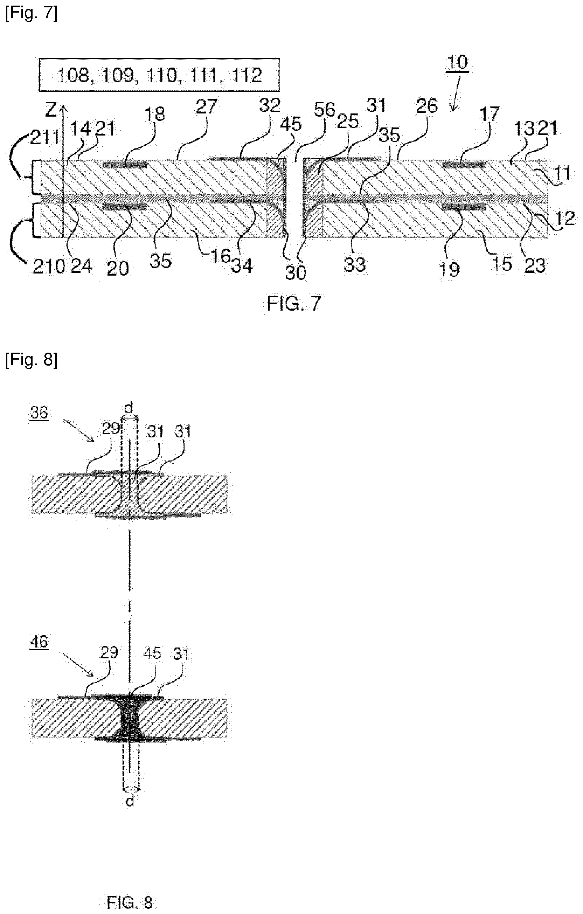

La figure 4 représente l'étape 104 de métallisation du panneau 200 rainuré obtenu à l'étape 103. Le procédé comprend ensuite une étape 105 de gravure par laser du panneau 200 rainuré métallisé de sorte à isoler des conducteurs horizontaux 33, 34. Cela s'applique aussi aux conducteurs horizontaux 31, 32 (non représentés sur la figure 4 mais visibles sur la figure 7). Cette étape 105 est représentée à la figure 5 par une vue de dessus des conducteurs horizontaux isolés entre eux après l'étape 105 de gravure.

La figure 4 représente également l'étape 106 de dépôt d'une deuxième résine époxy 45 dans l'espace formé par la rainure 54.

La figure 6 illustre l'étape 107 de réalisation d'une ou plusieurs couches photogravées de redistribution 28, 29 sur la surface supérieure du panneau. Cette étape permet de réaliser un ou plusieurs niveaux d'interconnexion horizontaux.

La figure 7 représente les dernières étapes du procédé de fabrication du procédé objet de l'invention. Le procédé comprend une étape 108 de retrait de la peau collante 51 pour obtenir une plaque 210, puis une étape 109 de dépôt d'une troisième résine époxy 35 sur la surface supérieure de la plaque 210. Puis vient une étape 110 d'empilement d'une deuxième plaque 211 sur la plaque 210, la plaque 210 étant recouverte de la troisième résine époxy 35 pour permettre le collage de la plaque 211 sur la plaque 210.

Pour finir, le procédé de fabrication du module électronique 3D 10 comprend une étape 111 de réalisation d'une rainure traversante 56 dans l'espace rempli de la deuxième résine époxy 45 et une étape 119 de métallisation de la rainure traversante 56 pour obtenir un conducteur vertical 30.

Dans des variantes du procédé de fabrication selon l'invention, lors de l'étape de réalisation de la rainure 54, la première profondeur 55 peut être inférieure à l'épaisseur de l'espace 53 rempli de la première résine époxy 25. Dans ce cas, un trou dit borgne est obtenu. Alternativement, la première profondeur 55 peut être égale à l'épaisseur de l'espace 53 rempli de la première résine époxy 25. On parle alors de trou traversant. La réalisation d'un tel trou, borgne ou traversant, permet d'obtenir une interconnexion inter niveaux dans le cas d'empilage de composants. En appliquant le principe de l'invention, l'interconnexion est là aussi courbe. Sur chacun des niveaux avant empilage, un alésage ou un perçage adapté est réalisé avec un outil de forme, et permet d'obtenir la forme courbe souhaitée.

La figure 7 représente ainsi une vue en coupe d'un module électronique 3D 10 selon l'invention. Le module électronique 3D 10 comprend selon une direction dite verticale Z un empilement d'au moins deux boîtiers électroniques 11, 12. Le module est apte à être assemblé à un circuit d'interconnexion (non représenté). Chacun des au moins deux boîtiers électroniques 11, 12 comprend :
a. des composants 13, 14, 15, 16 munis de plots d'interconnexion 17, 18, 19, 20 orientés vers une surface supérieure 21, 22, 23, 24 des composants 13, 14, 15, 16, lesdits composants 13, 14, 15, 16 étant au moins partiellement entourés de résine époxy 25, 35, 45, les plots d'interconnexion 17, 18, 19, 20 de chaque composant 13, 14, 15, 16 étant reliés par des couches de redistribution 26, 27, 28, 29 à des conducteurs verticaux 30 eux-mêmes destinés à être électriquement reliés au circuit d'interconnexion du module, et
b. des conducteurs horizontaux 31, 32, 33, 34, un conducteur horizontal 31, 32, 33, 34 et le conducteur vertical 30 auquel il est relié formant un conducteur électrique entre un plot d'interconnexion 17, 18, 19, 20 d'un composant 13, 14, 15, 16 et le circuit d'interconnexion.

Selon l'invention, l'interconnexion entre un conducteur horizontal 31, 32, 33, 34 et le conducteur vertical 30 auquel il est relié présente dans un plan vertical une courbure non nulle. L'interconnexion courbe entre les conducteurs horizontaux et le bus métal 30 permet au signal arrivant par le conducteur horizontal de suivre une trajectoire courbe pour atteindre le conducteur vertical. Comme on peut le voir sur la figure 7, la courbure de l'interconnexion entre le conducteur horizontal 31, 32, 33, 34 et le conducteur vertical 30 auquel il est relié forme une tangente avec le conducteur vertical 30. Il en ressort que l'invention assure l'interconnexion de puces empilées tout en assurant l'intégrité des signaux aux hyperfréquences.

Présentés généralement comme conducteur vertical, les conducteurs verticaux 30 peuvent être des bus ou des vias. L'invention correspond donc à une interconnexion entre conducteurs verticaux et horizontaux avec une courbure.

La figure 8 représente un mode de réalisation dans lequel le principe de l'invention est appliqué à un via 36, 46. Un via est un trou traversant, si bien que l'invention s'applique similairement à un conducteur vertical ou à un via.

En haut de la figure 8, le via 36 a un diamètre inférieur à 200 micromètres. La référence 31 du via 36 correspond au cuivre, à la fois en tant que conducteur horizontal, mais aussi pour remplir le via de faible diamètre. La couche photogravée 29 vient en contact du via de manière traditionnelle.

En bas de la figure 8, le via 46 a un diamètre supérieur à 200 micromètres. La référence 31 du via 36 correspond au cuivre, à la fois formant le conducteur horizontal et la partie conductrice verticale. Le trou est quant à lui rempli de résine 45. La couche photogravée 29 vient en contact du via de manière traditionnelle.

Un circuit imprimé est constitué de couches qui s'empilent. Pour obtenir un via selon l'invention, il est nécessaire de percer d'un côté du circuit avec un foret de forme, comme expliqué précédemment, puis de l'autre côté du circuit avec le foret de forme pour former le trou traversant 36, 46. Sur la figure 8, les vias 36, 46 ont fait l'objet de l'étape de métallisation et, le cas échéant, de dépôt de la résine époxy 45. Ainsi, le via présente une courbure dans son interconnexion avec les conducteurs horizontaux.

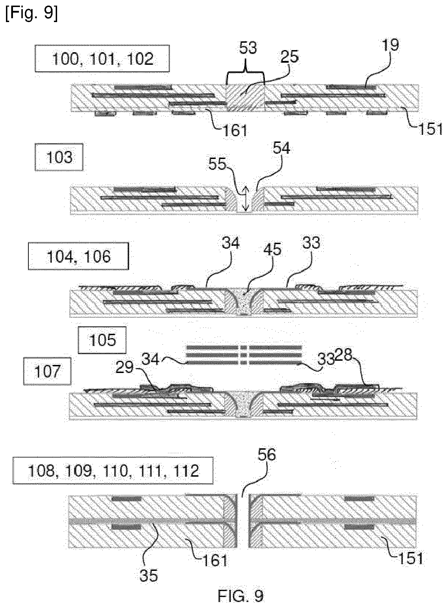

La figure 9 représente schématiquement une variante du procédé de fabrication du module électronique 3D selon l'invention avec des circuits imprimés 151, 161 (PCB). Dans cette variante, chaque PCB 151, 161 est considéré comme un composant et le même procédé tel que décrit précédemment s'applique.

Enfin, on peut noter que le principe de l'invention selon lequel l'interconnexion entre conducteurs horizontaux et conducteurs verticaux présente une certaine courbure s'applique également à des TSV (Thru Silicon Via). Le procédé d'obtention d'un tel TSV à interconnexion non orthogonale est réalisé de manière similaire à celui d'un via tel que décrit précédemment avec les vias 36, 46.

## Revendications

1. Module électronique 3D (10) comprenant selon une direction dite verticale (Z) un empilement d'au moins deux boîtiers électroniques (11, 12), le module étant apte à être assemblé à un circuit d'interconnexion, chacun des au moins deux boîtiers électroniques (11, 12) comprenant :
a. des composants (13, 14 ; 15, 16) munis de plots d'interconnexion (17, 18 ; 19, 20) orientés vers une surface supérieure (21, 22 ; 23, 24) des composants (13, 14 ; 15, 16), lesdits composants (13, 14 ; 15, 16) étant au moins partiellement entourés de résine époxy (25, 35, 45), les plots d'interconnexion (17, 18 ; 19, 20) de chaque composant (13, 14 ; 15, 16) étant reliés par des couches de redistribution (26, 27 ; 28, 29) à des conducteurs verticaux (30) eux-mêmes destinés à être électriquement reliés au circuit d'interconnexion du module, et
b. des conducteurs horizontaux (31, 32 ; 33, 34), un conducteur horizontal (31, 32, 33, 34) et le conducteur vertical (30) auquel il est relié formant un conducteur électrique entre un plot d'interconnexion (17, 18 ; 19, 20) d'un composant (13, 14 ; 15, 16) et le circuit d'interconnexion,
le module électronique 3D (10) étant **caractérisé en ce que** l'interconnexion entre un conducteur horizontal (31, 32 ; 33, 34) et le conducteur vertical (30) auquel il est relié présente dans un plan vertical une courbure non nulle et **en ce que** la courbure de l'interconnexion est recouverte de résine époxy.

2. Module électronique 3D (10) selon la revendication 1, dans lequel les conducteurs verticaux (30) sont des bus.

3. Module électronique 3D (10) selon la revendication 1, dans lequel les conducteurs verticaux (30) sont des vias (36, 46).

4. Module électronique 3D (10) selon la revendication 1, dans lequel la courbure de l'interconnexion entre le conducteur horizontal (31, 32 ; 33, 34) et le conducteur vertical (30) auquel il est relié forme une tangente avec le conducteur vertical (30)

5. Procédé de fabrication d'un module électronique 3D (10) apte à être assemblé à un circuit d'interconnexion, **caractérisé en ce qu'**il comprend les étapes suivantes :
a. Report (étape 100) de composants (15, 16) munis de plots d'interconnexion (17, 18 ; 19, 20) sur une première surface (50) d'une peau collante (51), une surface inférieure (52) des composants (15, 16) étant en contact avec la peau collante (51) et les plots d'interconnexion (19, 20) étant orientés vers une surface supérieure (23, 24) des composants (15, 16) ;
b. Dépôt (étape 101) d'une première résine époxy (25) dans l'espace (53) entre les composants (15, 16) et polymérisation (étape 102) de la résine (25) pour obtenir un panneau (200);
c. Réalisation (étape 103) d'une rainure (54) d'une première profondeur (55) dans l'espace (53) rempli de la première résine époxy (25), ladite rainure (54) étant de forme évasée vers la surface supérieure du panneau (200) et présentant latéralement une courbure ;
d. Métallisation (étape 104) du panneau (200) rainuré;
e. Gravure (étape 105) par laser du panneau (200) rainuré métallisé de sorte à isoler des conducteurs horizontaux (31, 32 ; 33, 34) ;
f. Dépôt (étape 106) d'une deuxième résine époxy (45) dans l'espace formé par la rainure (54) ;
g. Réalisation (étape 107) d'une ou plusieurs couches photogravées de redistribution (28, 29) sur la surface supérieure du panneau ;
h. Retrait (étape 108) de la peau collante (51) pour obtenir une plaque (210) ;
i. Dépôt (étape 109) d'une troisième résine époxy (35) sur la surface supérieure de la plaque (210);
j. Empilement (étape 110) d'une deuxième plaque (211) sur la plaque (210) recouverte de la troisième résine époxy (35) ;
k. Réalisation (étape 111) d'une rainure traversante (56) dans l'espace rempli de la deuxième résine époxy (45);
l. Métallisation (étape 112) de la rainure traversante (56) pour obtenir un conducteur vertical (30).

6. Procédé de fabrication d'un module électronique selon la revendication 5, dans lequel la première profondeur (55) est inférieure à l'épaisseur de l'espace (53) rempli de la première résine époxy (25).

7. Procédé de fabrication d'un module électronique selon la revendication 5, dans lequel la première profondeur (55) est égale à l'épaisseur de l'espace (53) rempli de la première résine époxy (25).
